# EUROPEAN PATENT APPLICATION

(11) **EP 1 550 527 A1**
(43) Date of publication of application: **06.07.2005**
(21) Application number: 03079211.3
(22) Date of filing: 30.12.2003
(51) Int. Cl.: B23K 26/04, B23K 26/00, H01L 21/78, H01L 21/304, B23K 26/38

(54) **Method of and arrangement for separating semiconductor elements formed in a wafer of semiconductor material, and semiconductor element separated therewith**

(71) Applicant: Advanced Laser Separation International (ALSI) B.V., 6641 TL, Beuningen (NL)
(72) Inventor: Van Panhuys, Haro Egbert Georg Roderik, 6641 TL Beuningen (NL); Chall, Hans Peter, 6641 TL Beuningen (NL)
(74) Representative: Valkonet, Rutger

(57) **Abstract**

The present invention provides a method of separating semiconductor elements formed in a wafer of semiconductor material using a laser for forming a score on a surface of said wafer. Said method comprises the steps of focussing (Step 4) said laser in a focus point on said wafer surface using a focussing lens, moving (Step 5) said laser relative to said wafer for forming said score, and prior to said step of moving (Step 5) said laser relative to said wafer, measuring (Step 2) and providing (Step 3) a height map of said wafer surface of heights of surface irregularities of said wafer surface relative to an imaginary reference plane parallel to said wafer surface. During the movement of the laser relative to the wafer, said laser is maintained focussed on said wafer surface (Step 6, with arrow 8).

## Description

### Field of the invention

The present invention relates generally to a method of and arrangement for separating semiconductor elements, and in particular to a method of separating semiconductor elements formed in a wafer of semiconductor material using a laser for forming a score on a surface of said wafer, comprising the steps of: focussing said laser in a focus point on said wafer surface using a focussing lens; and moving said laser relative to said wafer for forming said score.

The present invention further relates to an arrangement for separating semiconductor elements formed in a wafer of semiconductor material, comprising means for providing a laser beam for forming a score on a surface of said wafer, at least one focussing lens for focussing said laser in a focus point on said wafer surface, and means for moving said laser relative to said wafer for forming said score.

The present invention further relates to semiconductor element formed using a method or arrangement as described above.

### Background of the invention

Laser cutting and laser separation techniques for forming a score on a surface with high precision, are widely used in industry, for instance in the semiconductor industry. In the semiconductor industry, hundreds of semiconductor elements or micro circuits, packed on a single wafer, are to be separated. Separating these semiconductor elements is often performed by dicing, a process wherein a laser beam is focussed on the surface of the wafer and the laser is moved relative to the wafer for forming a score in between the semiconductor elements.

The focussing of the laser for forming a score must be extremely accurate in order to reduce the risk of loss of semiconductor elements during the separation process. Therefor, according to some separation techniques, height measurements are performed during the separation process which height measurements are fed back to the focussing means of the separation arrangement for adjusting the position of the focus point on the wafer surface. This reduces the risk of the laser being out of focus with respect to the wafer surface, due to height differences caused by, for instance, unflatness of the wafer clamping surface. Adjustment of the position of the focus point on the wafer surface may easily be performed by adjusting the height of the wafer relative to the focussing lens forming the focus point.

The method of performing height measurements during separation of the semiconductor elements has a number of disadvantages. The main disadvantage is that measuring the height during separation and correcting for irregularities on the wafer surface is a relatively slow process, due to the feed back process that has to be performed real time.

Another disadvantage is that the height measurements have to be performed as close to the focus point of the laser as possible in order to be sufficiently accurate. At the same time, however; the laser must have a clear line of sight with the wafer surface, such that a height sensor used for performing the height measurements should be placed at a certain distance from the laser beam.

### Summary of the invention

It is an object of the present invention to provide a method and arrangement for separating semiconductor elements formed in a wafer of semiconductor material, wherein said laser is accurately focussed on the wafer surface and adjusted for surface irregularities, at an optimal performance.

This and other objects are achieved by the present invention in that there is provided a method of separating semiconductor elements formed in a wafer of semiconductor material using a laser for forming a score on a surface of said wafer, comprising the steps of: focussing said laser in a focus point on said wafer surface using a focussing lens; moving said laser relative to said wafer for forming said score; and prior to said step of moving said laser relative to said wafer, measuring and providing a height map of said wafer surface of heights of surface irregularities of said wafer surface; wherein during said movement said laser relative to said wafer, said focus of said laser on said wafer surface is maintained by adjusting a location of said focus point relative to said wafer surface, using said height map.

By measuring and providing a height map prior to moving the laser relative to the wafer during the separation process, the surface irregularities on the wafer surface causing height differences that may result in defocussing of the laser on the wafer surface, can be very accurately measured due to the fact that measuring of the heights of the wafer surface is performed independently from the movement of the laser relative to the wafer surface, and artefacts caused, for instance, by small vibrations due to the movement of the laser relative to wafer surface are eliminated.

In addition, since a height map is measured of the wafer surface, a trajectory for the movement of the wafer relative to the wafer surface can be determined based on the height map and all corrections which have to take place in order to accurately focus the laser on the wafer surface may be determined prior to movement of the laser relative to the wafer, such that the movement itself, and thereby the separation process, can be performed much faster than conventional methods for separating semiconductor elements.

According to an embodiment of the present invention, said measuring and providing said height map comprises measuring and mapping distance variations between a height sensor and said wafer surface as a function of a location on said wafer surface. It will be appreciated that height differences can be measured accurately by using said height sensor.

In this embodiment, the average distance between the height sensor and the wafer surface may be fixed to a certain degree by either fixing the position of the height sensor relative to wafer surface or the position of the wafer surface relative to the height sensor, at least with respect to the direction wherein the height is measured. It will be appreciated that het height sensor must be enabled to move parallel to the wafer surface.

By either fixing the position of the height sensor relative to the wafer surface or the position of the wafer surface relative to the height sensor or both, at least in a direction wherein the height is measured, the height measurements can be performed more accurately since height differences due to variations in the fixed direction can be eliminated.

According to an embodiment of the present invention the optical path length of the laser may be adjusted by adjusting a focal distance of the focussing lens. This embodiment provides a relatively easy and straightforward method of adjusting the optical path length of the laser.

According to another embodiment of the present invention adjusting said optical path length of said laser comprises moving said focussing lens relative to said wafer surface, at least in a direction of said laser. This method can be performed very fast and can be performed directly dependent on the height map using straightforward calculations in order to convert the height differences caused by the surface irregularities into adjustment values.

In a preferred embodiment of the present invention, said focussing lens is mounted on a support structure comprising at least a base structure, at least one first arm and at least one second arm, wherein said first arm is pivotally connected to said base structure and said second arm is pivotally connected to said first arm, and wherein said focussing lens is connected to said second arm, wherein moving said focussing lens comprises a step of pivoting said second arm relative to said first arm and pivoting said first arm relative to said base structure. This embodiment comprises a construction wherein moving said focussing lens relative to said wafer surface in a direction of said laser is performed such that undesired movements in the direction perpendicular to said laser will be strongly reduced or even eliminated.

In an embodiment, the second arm extends substantially in counter direction to the first arm, and therefore, because the first arm is pivotally connected to the base structure, while the second arm is pivotally connected to the first arm, movements which are perpendicular to the main movement in the direction of the laser, caused by circular motion of the arms due to pivoting thereof, will be reduced and since these movements of both pivoting motions are in counter direction relative to each other. A movement in the direction perpendicular to the laser caused by pivoting of the second arm may therefor be compensated by a movement in counter direction thereto caused by pivoting of the first arm relative to the base structure.

Full compensation of these side way movements of the focussing lens may be achieved in another embodiment of the present invention, wherein the length of the first arm is substantially equal to the length of the second arm, and wherein said focussing lens is moved by pivoting said second arm relative to said first arm, and said first arm relative to said base structure over substantially a same angle.

It will be appreciated that since the magnitude of any undesired sideway movements caused by pivoting the arms, is a function of the angle over which the arm is pivoted and the length of the arm ((lenght arm)*(1-cos(angle))). Therefor if both the first arm and the second arm are of substantially a same length and the focussing lens is moved by pivoting both the first and the second over substantially a same angle, the sideways movement of the endpoints of both arms are equal but directed in counter direction, and will substantially compensate each other, eliminating the movements perpendicular to the direction of the laser.

Based on this same principle, if said first arm is of a different length than said second arm, the angles over which the first arm has to pivot relative to the second arm and the second arm has to pivot relative to the base structure (such that the sideways movements of both arms compensate each other) are dependent on each other and can be calculated.

Note further that embodiments wherein the first arm extends substantially in counter direction of the second arm provide benefits in that the construction can be kept relatively compact, whilst as explained it is very effective in eliminating movements perpendicular to the direction of the laser as described above. The benefit of compensating undesired movements perpendicular to the direction of the laser may however be achieved also in embodiments wherein the second arm extends in a different direction than the first arm. Such a construction is less compact, but comprises to a certain degree similar benefits with respect to compensation op movements perpendicular to the direction of the laser.

According to a second aspect of the present invention there is provided an arrangement for separating semiconductor elements formed in a wafer of semiconductor material, comprising means for providing a laser beam for forming a score on a surface of said wafer, at least one focussing lens for focussing said laser in a focus point on said wafer surface, and means for moving said laser relative to said wafer for forming said score, further comprising means for measuring heights of surface irregularities of said wafer surface, and means for providing a height map based on said height measurements, and means for adjusting a location of said focus point relative to said wafer surface using said height map.

According to an embodiment thereof said means for measuring height comprises a height sensor, wherein said height sensor is arranged for measuring distance variations between said height sensor and said wafer surface as a function of location on said wafer surface.

According to another embodiment of this invention, there is provided an arrangement according to the second aspect as described above, further comprising means for storing said measurements at least before providing said height map.

According to another embodiment of this aspect of the invention, said means for adjusting a location of said focus point relative to said wafer surface comprises means for moving said focussing lens at least in a direction parallel to said laser beam. It will be appreciated that the location of the focus point relative to the wafer surface may be adjusted by moving said focussing lens back and forth in a direction parallel to said laser beam.

According to another embodiment, said means for moving said focussing lens comprises a support structure for supporting said focussing lens comprising at least a base structure, at least one first arm and at least one second arm, wherein said first arm is pivotally connected to said base structure and said second arm is pivotally connected to said first arm, and wherein said focussing lens is connected to said second arm, said support structure being arranged for moving said focussing lens by pivoting said second arm relative to said first arm over a first angle and pivoting said first arm relative to said base structure over a second angle.

In this embodiment said second arm may extend substantially in counter direction to said first arm. In addition to this, said first and said second arm may be of substantially a same length, and said first angle is equal to said second angle. In this embodiment, undesired movements perpendicular to the movement of the focussing lens will be compensated effectively.

The pivotal connections in said means for moving said focussing lens may comprise at least one elastic hinge for forming a pivotal connection. An elastic hinge may be comprised by a very thin, but rigid and resilient connection between the two structures connected to each other. Alternatively, a leaf spring may be used to form a pivotal connection.

According to a third aspect of the present invention, there is provided a semiconductor element formed by separation of said element from a wafer using a method according to the present invention.

The present invention will now be further elucidated by a description of some embodiments thereof, wherein reference is made to the enclosed drawings and the reference signs comprised therein. The invention is not limited to the embodiments disclosed, which are provided for explanatory purposes only.

### Brief description of the drawings

Figure 1 is a schematic drawing of a method according to the present invention.
Figure 2 is a schematic drawing of the principle of the support structure used for adjusting the height of the focussing lens.
Figure 3 shows the support structure of an arrangement according to the present invention.
Figure 4 shows a support structure of an arrangement according to the present invention, including focussing lens and height sensor.
Figure 5 shows a bottom view of a part of the support structure of figure 4, including focussing lens and height sensor.

### Detailed description of the drawings

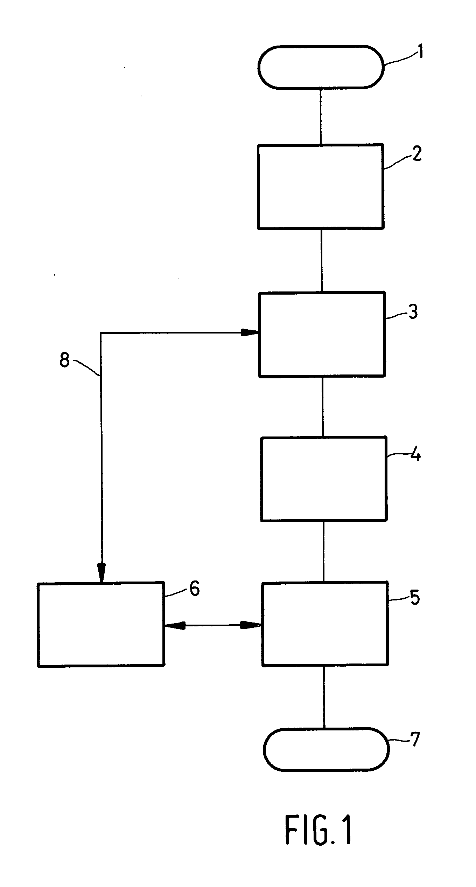

Figure 1 is a schematic drawing of a method according to the present invention, for separating semiconductor elements formed in a wafer of semiconductor material. From the start 1, the method includes a step 2 of position dependent measuring of the actual height of a height sensor above the wafer surface, wherein the wafer surface comprises surface irregularities causing height differences dependent on the location measured. This step 2 may be performed by moving the height sensor across the surface and registering the measured heights and the actual location. Said measurements may be temporarily stored in a memory. In step 3, a height map of the wafer surface is constructed based on the height measurements provided in step 2, which are stored in the memory. In step 4 the actual step of separating semiconductor elements starts by focussing the laser in a focus point on the wafer surface. It will be appreciated that the laser is focussed in between the semiconductor elements on the wafer surface.

After said step 4 of focussing the laser, the laser is moved relative to the wafer in step 5 for forming a score on the wafer surface. It will be appreciated that step 5 can be performed by either fixing the laser and moving the wafer or moving the laser and fixing the wafer or moving both relative to each other. During step 5, the focussing of the laser is maintained by adjusting the optical path length of the laser using the height map provided in step 3. In step 6, the height map provided in step 3 is repeatedly consulted, as indicated by double arrow 8. When all semiconductor elements are separated from the wafer, step 5 is completed, and the method will end in step 7.

Adjustment of the optical path length of the laser in step 6, can be performed in various ways. In one embodiment of the present invention the laser is refocussed by adjusting the focal distance of the focussing lens. However in another embodiment, the focussing itself is moved in the direction of the laser, in order to displays the focal point at the wafer surface such that the focal point is continuously adjusted dependent on the height differences of the wafer surface due to the surface irregularities.

In the latter case, wherein the focussing lens itself is adjusted by moving the focussing lens back and forth in the direction of the laser, it is important to carry out this movement accurately such that any sideways movements, i.e. movements perpendicular to the direction of the laser, are reduced and eliminated as much as possible. In addition the height of the focussing lens above the wafer surface must be very accurately set, with an accuracy which is less then 5 µm. This accuracy may be achieved using a support structure described herein below.

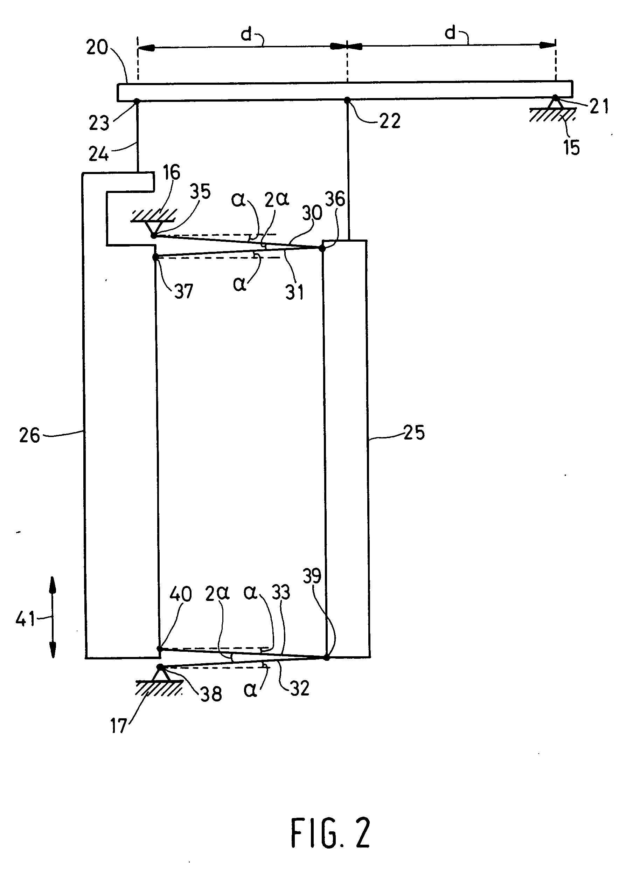

Figure 2 schematically shows the principle of operation of such a support structure. The support structure used with the present invention comprises a base structure, which is omitted in figure 2 for clarity reasons, but which is schematically indicated by anchoring points 15, 16 and 17. To anchoring point 15 a lever 20 is pivotal connected using pivotal connection 21. Approximately at half the distance between pivotal connection 21 and the end point of lever 20, a support rod 25 is suspended from point 22. At the end of lever 20, from point 23 using a rigid suspension 24, there is suspended a carriage 26 to which the focussing lens (not shown) will be connected. Suspension points 22 and 23 on lever 20 are chosen such that the distance d between suspension point 22 and pivotable connection 21 equals distance d between suspension point 22 and 23. The distance from suspension point 23 tot pivotable connection 21 relates to the distance between suspension point 22 and pivotable connection 21 as 2:1. From anchoring point 16, a first arm 30 extends in the direction of support rod 25, where it is pivotably connected with pivotable connection 36. First arm 30 is pivotably connected to anchoring point 16 by pivotable connection 35. A second arm 31 pivotably connects to support rod 25 and extends towards carriage 26, where it is pivotally connected using pivotal connection 37. Note that first arm 30, and second arm 31, extend in counter direction to each other.

Similar to this, from anchoring point 17, a first arm 32 extends towards support rod 25 where it is pivotally connected using pivotal connection 39. Again first arm 32 is pivotally connected to anchoring point 17 with pivotal connection 38. From pivotal connection 39 a second arm 33 extends from supporting rod 25 towards carriage 26, where it is pivotally connected by pivotal connection 40. It will be appreciated that the support structure of figure 2 is arranged for accurately moving carriage 26 in the directions indicated by double arrow 41.

The support structure shown in figure 2 is operated as follows. A movement in the direction indicated by double arrow 41 may either be forced upon carriage 26, or on lever 20. Suppose a movement is forced upon carriage 26 by for instance a servo-motor (not shown). Since suspension 24 between carriage 26 en lever 20 is rigid, the movement forced upon carriage 26 is also forced on lever 20 through suspension 24. Due to the relation between the distance of suspension points 23 en 22 to pivotal connection 21, a displacement of magnitude f (not shown) in carriage 26 due to the movement forced thereon, leads to displacement of magnitude ½ f in support rod 25.

Pivotal connections 35, 36 and 37 are positioned relative to each other, such that a pivoting angle between the first arm 30 and a imaginary horizontal reference plane (indicated by any of the dotted line), and a pivoting angle between the second arm 31 and a imaginary horizontal reference plane (indicated by any of the dotted lines) are both equal, as indicated by α. The angle between the first arm 30 and the second arm 31 is equal to 2α.

Since first arm 30 is pivotally connected to anchoring point 16, and anchoring point 16 is a fixed point in the space, the horizontal displacement at pivotal connection 36 due to pivoting said first arm 30 around pivotal connection 35 over an angle α is equal to (r-r*cosα), wherein r is the length of first arm 30 (not shown in figure 2). Taking pivotal connection 36 as a reference point, the horizontal displacement of pivotal connection 37 due to pivoting of second arm 31 relative to an imaginary horizontal plane around pivotal connection 36 over an angl e α, equals (r-r*cosα). Therefore both horizontal displacements of the first and second arm 30 and 31, relative to their pivoting points 35 and 36 respectively, are equal to (r-r*cosα), however since second arm 31 extends in counter direction to first arm 30, the horizontal displacement of second arm 31 is in counter direction to the horizontal displacement of first arm 30, and as a result the horizontal displacement of pivotal connection 37 relative to pivotal connection 35 is effectively compensated.

It will be understood that first arm 32 and second arm 33, pivoting around pivotal connections 38, 39 and 40, wherein pivotal connection 38 connects first arm 32 to anchoring point 17 and pivotal connection 39 connects second arm 33 to supporting rod 25, operate in exactly the same way as pivotal arms 30 and 31.

Based on the operating principle explained above, the displacement of carriage 26 in a direction perpendicular to the desired direction indicated by double arrow 41, is effectively eliminated by the construction shown in figure 2.

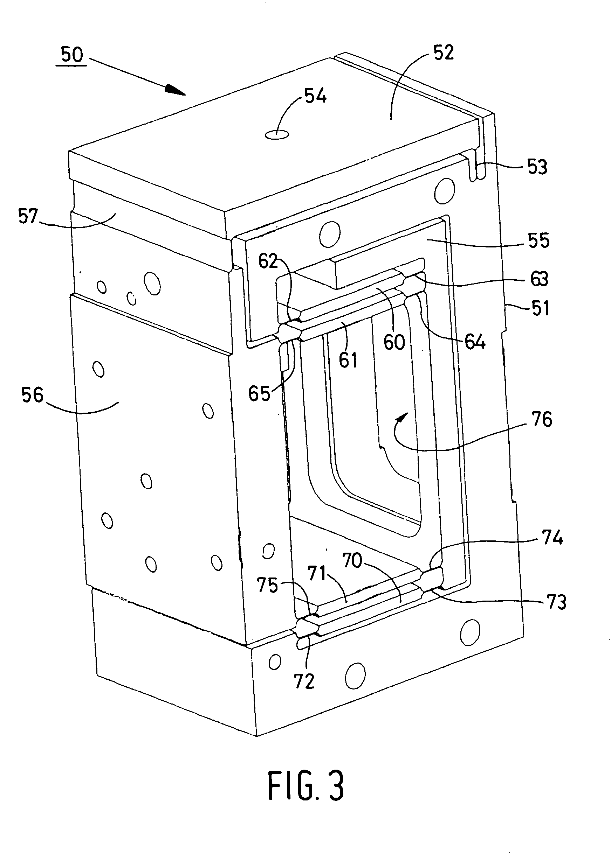

Figure 3 shows a support structure of an arrangement according to the present invention. The support structure comprises a base structure 51, which facilitate the required anchoring points in the construction (as described in relation to figure 2). To base structure 51 a lever 52 is connected via pivotal connection 53. A carriage 56 is connected at the end of lever 52 by pivotal connection 57. Note that pivotal connection 57 forms a ridged suspension. Halfway in between pivotal connection 57 and pivotal connection 53, hidden underneath lever 52, a suspension cord (not visible) extends towards supporting rod 55, and said suspension cord is fixed to lever 52 using connection means 54 visible at the top of the lever. A hole in base structure 51 enables free movement of the suspension cord, extending in between lever 52 and supporting rod 55. From pivotal connection 62 connected to base structure 51 a first arm 60 extends towards pivotal connection 63 on supporting rod 55. Then in between pivotal connection 64 on supporting rod 55 and pivotal connection 65 on carriage 56, a second arm 61 extends from supporting rod 55 towards carriage 56.

Similar to the above, in the lower part of the support structure 50, a first arm 70 extends in between pivotal connection 72 on base structure 51 and pivotal connection 73 on supporting rod 55. Then, in between pivotal connection 74 and pivotal connection 75 on supporting rod 55 and carriage 56 respectively, a second arm 71 extends from supporting rod 55 towards carriage 56, in counter direction to first arm 70. Note that the construction of support structure 50 is based on the principal of the support structure schematically shown in figure 2. The pivotal connections 53, 57, 62, 63, 64, 65, 72, 73, 74 and 75 are formed by elastic hinges. An elastic hinge is formed by a thin, rigid, resilient connection between two structures, such as elastic hinge 62 formed by a very thin rigid connection between base structure 51 and first arm 60. The benefit of using elastic hinges is that an elastic hinge, such as hinges 53, 57, 62, 63, 64, 65, 72, 73, 74 and 75, does not have any hysteresis or backlash. Elastic hinges are therefor very useful for high precision mechanics such as the support structure of the arrangement of the present invention. Note that elastic hinges may be replaced by, for instance, constructions of leaf and other springs, constructions of pens, hinges based on resilient walls between closely spaced adjacent holes, or other pivotal connections having no or almost no hysteresis or backlash.

In the support structure 50 shown in figure 3, base structure 51 and supporting rod 55 further comprise an opening 76 arranged for receiving, for instance, a servo-motor for forcing a movement on carriage 56, similar to the movement forced on carriage 26 in figure 2.

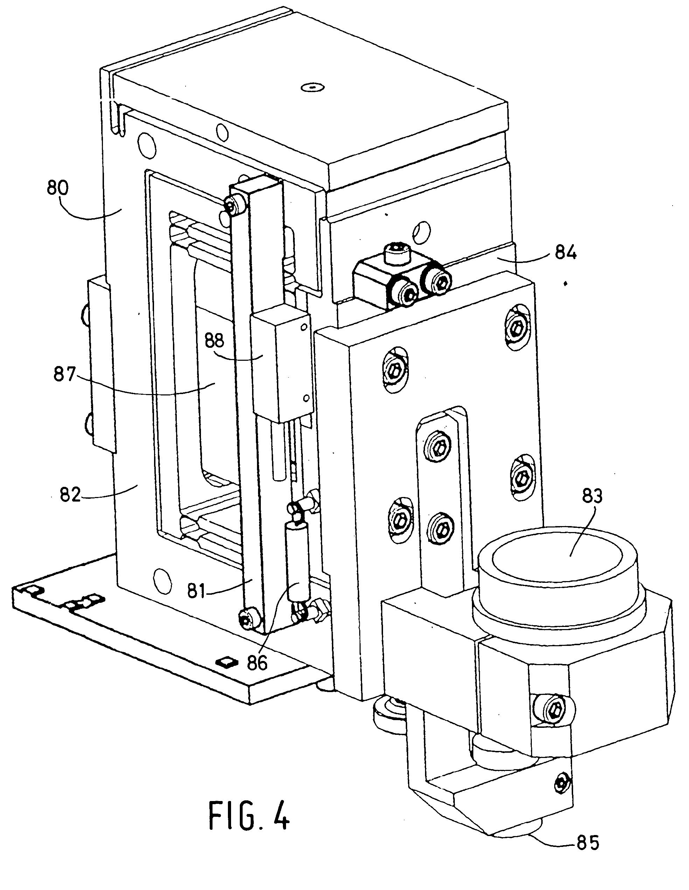

Figure 4 shows a support structure 80 such as support structure 50 in figure 3, wherein a focussing lens 83 is mounted on carriage 84 of the support structure 80. Partially hidden by the rest of the arrangement, a servo-motor 87 is shown, arranged for forcing a movement onto carriage 84. Connected to base structure 82 of support structure 80 the arrangement comprises a position sensor 88 mounted on a bracket 81, for accurately measuring the actual position of carriage 84. A signal provided by said position sensor, may for instance be used in the arrangement for controlling the servo-motor 87. Note that spring 86 connecting carriage 84 with base structure 82 is comprised by the arrangement in order to support forcing of a movement induced by servo-motor 87 onto carriage 84, and forcing carriage 84 back to an equilibrium position if necessary. In the lower part of the support structure, underneath the focussing lens 83, but mounted such that a laser focussed by focussing lens 83 on to a wafer surface has a clear line of sight, the arrangement comprises a height sensor 85 for measuring surface irregularities of the way for surface.

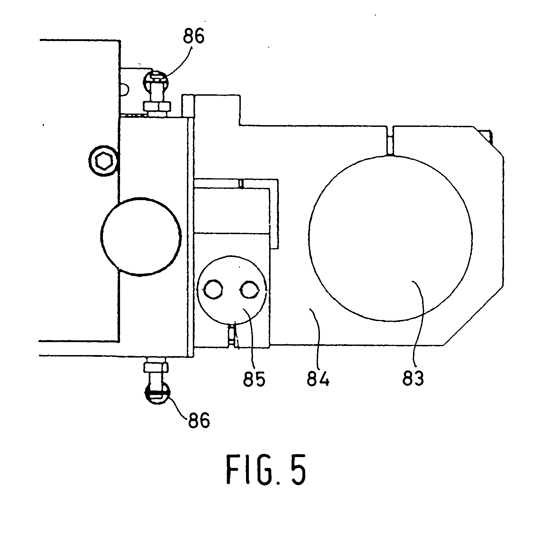

Figure 5 shows a partial enlargement of a bottom view of the arrangement shown in figure 4, wherein it is clearly shown that height sensor 85 is placed such that focussing lens 83 has a clear line of sight to the wafer surface. Connecting the height sensor 85 to carriage 84 (to which the focussing lens 83 is also connected) is important in the embodiment shown in figure 5.

The support structure 80 may be constructed in one piece, which provides benefits in the manufacturing process and with respect to accuracy of the method and arrangement. However, alternatively, sufficiently good results may be achieved by constructing the base structure 80 from a plurality of parts, connected for instance by screws, bolts, welds, glue or any other suitable means.

It will be understood that the support structure used in the arrangement according to the present invention may be constructed of any suitable rigid material, such as a metal or a suitable (reinforced) polymer.

For the purpose of comprehensiveness, it is noted here that numerous modifications and variations of the present invention are possible in the light of the above teachings. It is therefor understood that, within the scope of the appended claims, the invention may be practised otherwise than as specifically described herein.

## Claims

1. Method of separating semiconductor elements formed in a wafer of semiconductor material using a laser for forming a score on a surface of said wafer, comprising the steps of:
focussing said laser in a focus point on said wafer surface using a focussing lens;
moving said laser relative to said wafer for forming said score; and
prior to said step of moving said laser relative to said wafer, measuring and providing a height map of said wafer surface of heights of surface irregularities of said wafer surface;
wherein during said movement of said laser relative to said wafer, said focus of said laser on said wafer surface is maintained by adjusting a location of said focus point relative to said wafer surface, using said height map.

2. Method according to claim 1, wherein measuring and providing said height map comprises measuring and mapping distance variations between a height sensor and said wafer surface as a function of a location on said wafer surface.

3. Method according to any of the previous claims, wherein adjusting said location of said focus point comprises adjusting a focal distance of said focussing lens.

4. Method according to any of the claims 1 or 2, wherein adjusting said location of said focus point comprises moving said focussing lens relative to said wafer surface, at least in a direction of said optical path of said laser.

5. Method according to claim 4, wherein said focussing lens is mounted on a support structure comprising at least a base structure, at least one first arm and at least one second arm, wherein said first arm is pivotally connected to said base structure and said second arm is pivotally connected to said first arm, and wherein said focussing lens is connected to said second arm, wherein moving said focussing lens comprises a step of pivoting said second arm relative to said first arm and pivoting said first arm relative to said base structure.

6. Method according to claim 5, wherein said second arm extending substantially in counter direction to said first arm.

7. Method according to claim 6, wherein said first arm and said second arm are of substantially equal length, and wherein said focussing lens is moved by pivoting said second arm relative to said first arm, and said first arm relative to said base structure over substantially an equal angle.

8. Arrangement for separating semiconductor elements formed in a wafer of semiconductor material, comprising means for providing a laser beam for forming a score on a surface of said wafer, at least one focussing lens for focussing said laser in a focus point on said wafer surface, and means for moving said laser relative to said wafer for forming said score, further comprising means for measuring heights of surface irregularities of said wafer surface, and means for providing a height map based on said height measurements, and means for adjusting a location of said focus point relative to said wafer surface using said height map.

9. Arrangement according to claim 8, wherein said means for measuring heights comprises a height sensor, said height sensor being arranged for measuring distance variations between said height sensor and said wafer surface as a function of a location on said wafer surface.

10. Arrangement according to claim 9, further comprising means for moving said height sensor relative and substantially parallel to said wafer surface.

11. Arrangement according to any of the claims 8-10, further comprising means for storing said measurements at least before providing said height map.

12. Arrangement according to any of the claims 8-11, wherein said means for adjusting a location of said focus point relative to said wafer surface comprises means for adjusting a focal distance of said focussing lens.

13. Arrangement according to any of the claims 8-11, wherein said means for adjusting a location of said focus point relative to said wafer surface comprises means for moving said focussing lens at least in a direction parallel to said laser beam.

14. Arrangement according to claim 13, wherein said means for moving said focussing lens comprises a support structure for supporting said focussing lens comprising at least a base structure, at least one first arm and at least one second arm, wherein said first arm is pivotally connected to said base structure and said second arm is pivotally connected to said first arm, and wherein said focussing lens is connected to said second arm, said support structure being arranged for moving said focussing lens by pivoting said second arm relative to said first arm over a first angle and pivoting said first arm relative to said base structure over a second angle.

15. Arrangement according to claim 14, wherein said second arm extends substantially in counter direction to said first arm.

16. Arrangement according to claim 15, wherein said first and said second arm are of substantially a same length, and wherein said first angle is equal to said second angle.

17. Arrangement according to any of the claims 13-16, wherein said means for moving said focussing lens comprises at least one elastic hinge for forming a pivotal connection.

18. Arrangement according to any of the claims 13-16, wherein said means for moving said focussing lens comprises at least one leaf spring for forming a pivotal connection.

19. Arrangement according to any of the claims 13-18, wherein said means for moving said focussing lens further comprises means for forcing a movement onto said focussing lens.

20. Semiconductor element formed by separation of said element from a wafer using a method according to any of the claims 1-7.
